# EUROPEAN PATENT APPLICATION

(11) **EP 0 822 585 A2**
(43) Date of publication of application: **04.02.1998**
(21) Application number: 97112628.9
(22) Date of filing: 23.07.1997
(51) Int. Cl.: H01L 21/316, H01L 23/485

(54) **Stress control by fluorination of silica film**

(30) Priority: 02.08.1996 US 691983
(71) Applicant: APPLIED MATERIALS, INC., Santa Clara, California 95050 (US)
(72) Inventor: Nowak, Romauld, Cupertino, California 95014 (US); Verna, Amrita, Pittsburgh, Pennsylvania 15232 (US); Pickering, Jonathan C., Santa Clara, California 95054 (US); Robles, Stuardo, Sunnyvale, California 94087 (US); Sinha, Ashok, Palo Alto, California 94306 (US)
(74) Representative: Kirschner, Klaus Dieter, Dipl.-Phys.

(57) **Abstract**

A method and apparatus for controlling the intrinsic stress level of a deposited silicon oxide film. In one embodiment, the method includes incorporating a select amount of a halogen element into the film to obtain a resulting film having the desired stress level. In another embodiment, the method of the present invention includes the step of tuning the stress level of a silicon oxide film deposited under high density plasma conditions by incorporating a predetermined amount of fluorine into the film.

## Description

The present invention relates to the deposition of dielectric layers during wafer processing, and more specifically, to a method and apparatus for controlling the intrinsic stress in deposited silicon oxide layers.

One of the primary steps in the fabrication of modern semiconductor devices is the formation of a thin film on a semiconductor substrate by chemical reaction of gases. Such a deposition process is referred to as chemical vapor deposition or CVD. Conventional thermal CVD processes supply reactive gases to the substrate surface where heat-induced chemical reactions produce a desired film. The high temperatures at which some thermal CVD processes operate can damage device structures having metal layers. A common plasma-enhanced CVD (PECVD) process, on the other hand, promotes disassociation of the reactant gases by the application of radio frequency (RF) energy to a reaction zone near the substrate surface, thereby creating a plasma of highly-reactive ionic species. The high reactivity of the released ionic species reduces the energy required for a chemical reaction to take place, and thus lowers the required temperature for such CVD processes.

The relatively low temperature of a PECVD process makes such processes ideal for the formation of insulating layers over deposited metal or polysilicon layers. One common type of film used for such insulating layers (also referred to as dielectric layers) is silicon oxide. Silicon oxide films are well suited for dielectric layers because of their good electrical and physical properties.

Semiconductor device geometries have dramatically decreased in size since such devices were first introduced several decades ago. Since then, integrated circuits have generally followed the two year/half-size rule (often called Moore's Law) which means that the number of devices that will fit on a chip doubles every two years. Today's wafer fabrication plants are routinely producing integrated circuits with 0.5 mm and even 0.35 mm features, and tomorrow's plants soon will be producing devices with even smaller geometries.

As device sizes become smaller and integration density increases, it becomes important that certain film characteristics are kept within specified ranges. One such characteristic is the intrinsic stress level of deposited films. Specifically, it is important that manufacturers of smaller geometry devices be able to precisely control the stress level of deposited layers. Intrinsic stress levels above or below certain levels may cause wafer bowing, cracking, void formation or other defects.

The intrinsic stress level of a silicon oxide film deposited in a standard, capacitively coupled, parallel plate PECVD reactor (hereinafter referred to as a "standard PECVD reactor") can be controlled by adjusting a number of different processing conditions. One technique of controlling the intrinsic stress of a silicon oxide film is to adjust the RF power level in a standard PECVD reactor. Integrated circuit manufacturers employ this and other techniques to ensure that the intrinsic stress level of deposited silicon oxide layers is within acceptable levels.

In addition to stress control, other issues that have become increasingly important as device geometries have become smaller include lowering the dielectric constant of intermetal dielectric (IMD) and other insulation layers and increasing the ability of the deposited insulating layer to fill closely spaced gaps (referred to as the film's "gap-fill" capability). For some applications, the electrical and physical characteristics such as dielectric constant and gap-fill properties of silicon oxide films deposited in a standard PECVD reactor are no longer sufficient.

One of the more promising solutions to the dielectric constant and gap-fill problems is the incorporation of fluorine or other halogen elements, such as chlorine or bromine, into the silicon oxide film. Fluorine, being less corrosive than other members of the halogen family, is generally the preferred halogen dopant for silicon oxide films. Fluorine-doped silicon oxide films are also referred to as fluorosilicate glass films or FSG.

Generally, FSG films have a lower dielectric constant than their silicon oxide counterparts and exhibit better gap-fill properties. Thus, many manufacturers prefer to include fluorine in various dielectric layers, and particularly in intermetal dielectric layers.

Unless certain procedures are followed during PECVD deposition, silicon oxide films that incorporate fluorine tend to be more porous and less dense than similarly formed undoped silicon oxide films. Thus, controlling the stress of such films is an important aspect of their deposition. One method of controlling the stress of these films is to densify the films (increase the compressive stress of the films) by adjusting the low frequency RF power used in the reaction. The application of a *de minimis* level of low frequency RF power during deposition of the FSG film can change the intrinsic stress of the film from what would otherwise be a tensile film to a compressive one. Increasing the low frequency RF power beyond this *de minimis* amount further increases the intrinsic compressive stress within the deposited film.

Another promising solution to the gap-fill problem is the use of high density plasma (HDP) CVD reactors in which inductively coupled coils are employed to generate the plasma under very low pressure conditions (in the millitorr range). A plasma generated by such an HDP CVD reactor has an ion density approximately two orders of magnitude or more greater than the ion density of a standard, capacitively coupled PECVD plasma. It is believed that the low chamber pressure employed in HDP CVD reactors provides active species having a long mean free path. This factor, in combination with the density of the plasma, permits a significant number of plasma constituents to reach even the bottom portions of deep, tightly spaced gaps, and deposits a film with excellent gap-fill properties. Also, argon or a similar heavy inert gas is introduced into the reaction chamber to promote sputtering during deposition. It is believed that the sputtering element of HDP deposition etches away deposition on the sides of gaps being filled, which also contributes to the increased gap-fill of HDP-deposited films. Some HDP reactors allow the plasma to be biased toward the substrate by the application of an electric field to further promote the sputtering effect. Thus, the use of such HDP CVD reactors is becoming increasingly important and they have been used to deposit both silicon oxide and FSG films.

For at least two reasons, stress control problems are even more apparent in such HDP CVD reactors. First, HDP CVD films generally have a greater intrinsic stress level than standard PECVD films. Thus, controlling this increased stress so that it is within an acceptable range is an important issue. Second, varying the RF power of the HDP CVD-formed plasma allows stress to be controlled to a level within a relatively small window (e.g., between -1.0x10⁹ dynes/cm² and -1.5 x 10⁹ dynes/cm² in one application), but varying RF power does not allow the intrinsic stress level of the deposited film to be altered to a level significantly outside of that window. Although the exact reasons for this phenomenon are not entirely understood, it is believed to be related to the extreme high density or saturation of the plasma. Additionally, adjusting the RF power to set the stress of the deposited film near the lower stress levels within the window can have an adverse effect on the film's gap-fill properties.

In the past, the stress in HDP films was controlled in a variety of different manners. One example of such a stress control regime deposited a low stress PECVD or other type of film over the HDP film. Using this dual layer (high stress/low stress) approach permits stress control. Such an approach, however, also increases processing time, and thus decreases throughput as wafers are transferred from an HDP chamber to a PECVD or other type of chamber. Even if deposition of the composite layer can take place in a single chamber, wafer throughput is still adversely effected while process conditions such as pressure and temperature are adjusted for deposition of the dual layers.

Accordingly, it is desirable and important to precisely control the stress level of deposited films such as halogen-doped silicon oxide layers deposited under PECVD conditions without adversely affecting gap-fill properties of the film. Also, it is desirable and important to be able to precisely control the stress in silicon oxide films formed by HDP CVD processing techniques.

The present invention has the object to provide a method and apparatus for controlling the intrinsic stress in a deposited silicon oxide film without adversely affecting the gap-fill capability of the film.

According to the method of the present invention, a predetermined amount of a halogen element is introduced into the silicon oxide film. The actual percentage of the halogen element incorporated into the film is selected according to the desired intrinsic stress level of the film.

In a preferred embodiment, a predetermined amount of fluorine is introduced into the reaction chamber to deposit an FSG layer having a stress level within a desired range. The intrinsic stress of the deposited FSG layer is controlled by the rate at which a fluorine-containing source is introduced into the process gas. Depending on the actual rate at which the fluorine source is introduced, the intrinsic stress level of the FSG film can be tuned to a desired stress level from about -2.0x10⁹ dynes/cm² to that of a low-stress tensile film. In another preferred version of this embodiment, a selected amount of fluorine is introduced into the reaction chamber to set the stress level of the deposited film to a level from about -1.0x10⁹ dynes/cm² to - 0.5x10⁹ dynes/cm².

In another embodiment of the method of the present invention, a predetermined amount of fluorine is introduced into a reaction chamber along with a process gas including a silicon source and oxygen; a plasma of at least 1x10¹¹ ions/cm³ is formed to deposit a fluorine-doped silicon oxide film. The intrinsic stress of the deposited silicon oxide layer is controlled by selecting an appropriate rate at which a fluorine-containing source is introduced into the reaction chamber. Depending on the actual rate at which the fluorine source is introduced, the intrinsic stress level of the FSG film can be tuned to a desired stress level from about -1.5x10⁹ dynes/cm² to that of a low stress tensile film. In preferred versions of this embodiment, the plasma is formed in an inductively coupled HDP CVD reactor. A selected amount of fluorine is introduced into the HDP CVD reaction chamber to set the stress level of the deposited film to a level from about -1.0x10⁹ dynes/cm² to -0.5x10⁹ dynes/cm².

In some embodiments where it is desirable to not alter film characteristics such as dielectric constant, gap-fill properties and film uniformity and stability, the selected rate at which the fluorine source is introduced into the chamber can be 20% or less of the total deposition gas flow into the chamber. In still other embodiments the fluorine source can be 10% or less of the total gas flow. The addition of such a relatively small amount of fluorine in these embodiments is used to control the stress of the deposited silicon oxide film to a level less than -1.0x10⁹ dynes/cm².

Further preferred embodiments of the invention and the features thereof are given in the appended claims and subclaims.

Preferred embodiments of the invention will now be described in detail in conjunction with the accompanying drawings in which
Fig. 1A is a vertical, cross-sectional view of one embodiment of a simplified high density chemical vapor deposition apparatus according to the present invention;
Fig. 1B is a diagram of an exemplary system monitor used in conjunction with the exemplary CVD processing chamber of Fig. 1;
Fig. 1C is a flow chart of an exemplary process control computer program product used to control the CVD processing chamber of Fig. 1A;
Fig. 2 is a vertical, cross-sectional view of one embodiment of a simplified plasma-enhanced, parallel plate chemical vapor deposition apparatus according to the present invention;
Fig. 3 is a graph showing the effect of fluorine dopant flow on the intrinsic stress level of a silicon oxide film deposited in an HDP CVD reactor;
Fig. 4 is a graph showing the effect of variations in low frequency RF power on the intrinsic stress level of a fluorine-doped silicon oxide film deposited in a capacitively coupled PECVD reactor;
Fig. 5 is a graph showing the effect of fluorine dopant flow on the intrinsic stress level of a silicon oxide film deposited in a capacitively coupled PECVD reactor; and
Fig. 6 is a simplified cross-sectional view of an integrated circuit 200 according to the present invention.

### I. Exemplary CVD Systems

### A. An Exemplary High Density Plasma CVD Systems

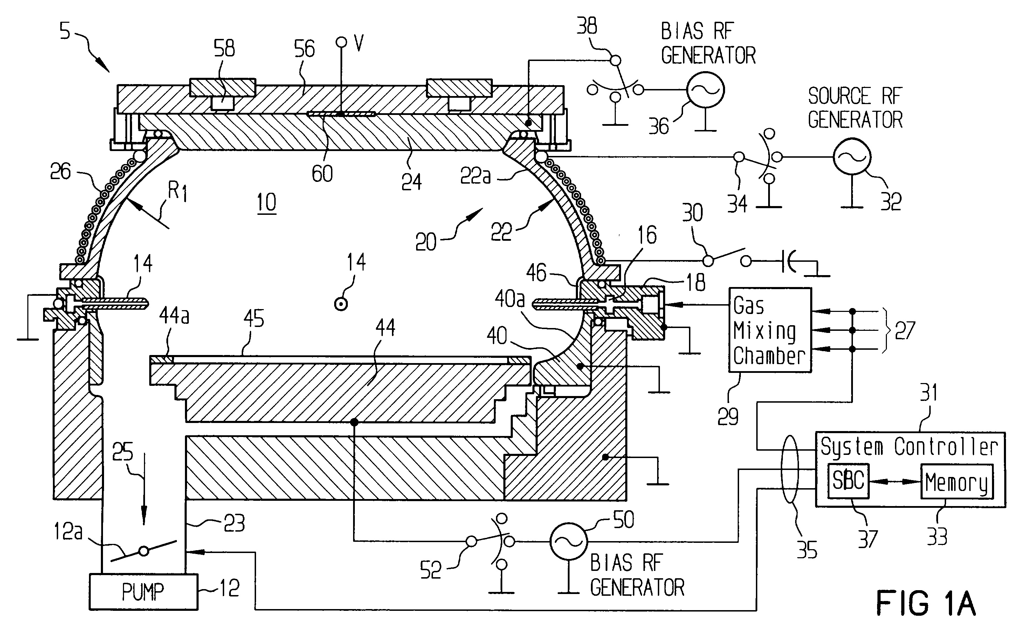

Fig. 1A illustrates one embodiment of a HDP CVD system 5 in which the dielectric layer according to the present invention can be deposited. HDP CVD system 5 includes a vacuum chamber 10, a vacuum pump 12, a bias RF (BRF) generator 36, and a source RF (SRF) generator 32.

Vacuum chamber 10 includes a ceiling 12 consisting of a sidewall 22 and a disk-shaped ceiling electrode 24. Sidewall 22 is made of an insulator such as quartz or ceramic and supports helically coiled antenna 26.

Deposition gases and liquids are supplied through lines 27, having control valves not shown, into a gas mixing chamber 29 where they are combined and sent to gas supply ring manifold 16. Generally, each gas supply line for each process gas includes (i) safety shut-off valves (not shown) that can be used to automatically or manually shut off the flow of process gas into the chamber, and (ii) mass flow controllers (MFCs) (also not shown) that measure the flow of gas through the gas supply lines. When toxic gases are used in the process, the several safety shut-off valves are positioned on each gas supply line in conventional configurations.

Gas injection nozzles 14 are coupled to gas supply ring manifold 16 and disperse deposition gases introduced into manifold 16 to a substrate 45 resting on a pedestal 44 within chamber 10. Pedestal 44 may be moved up and down by a motor (not shown) into various processing positions. Additionally, pedestal 44 may contain an electrostatic chuck or similar mechanism to restrain the wafer during processing and may also contain cooling passages and other features.

Gas supply ring manifold 16 is positioned within a housing 18. Housing 18 is protected from reagents by a skirt 46. Skirt 46 is composed of a substance, such as quartz, ceramic, silicon or polysilicon, which is resistant to the reagents used in the HDP CVD process. The bottom of vacuum chamber 10 may include an annular liner 40, which itself may be made removable.

An inductively coupled plasma of the deposition gases can be formed adjacent to substrate 45 by RF energy applied to coiled antenna 26 from source RF generator 32. Source RF generator 32 can supply either single or mixed frequency RF power (or other desired variation) to coiled antenna 26 to enhance the decomposition of reactive species introduced into vacuum chamber 10. A plasma formed in such a manner has a relatively high density (on the order of 10¹¹ to 10¹² ions/cm³) as compared with standard PECVD reactors. Deposition gases are exhausted from chamber 10 through exhaust line 23 as indicated by arrow 25. The rate at which gases are released through exhaust line 23 is controlled by throttle valve 12a.

Ceiling electrode 24 is held in place by a lid 56. Lid 56 is cooled by cooling jackets 58, but ceiling electrode 24 can be heated by a resistive heater 60 to accelerate cleaning rates or alter process parameters. Ceiling electrode 24 is a conductor and may be connected to either ground, to a BRF generator 36, or left unconnected (allowed to float), by properly setting switch 38. Similarly, pedestal 44 may be connected to either ground, to a BRF generator 50 or left unconnected (allowed to float), by properly setting switch 52. The settings of these switches depends upon the plasma's desired characteristics. BRF generators 36 and 50 can supply either single or mixed frequency RF power (or other desired variation). BRF generators 36 and 50 may be separate RF generators, or may be a single RF generator connected to both ceiling electrode 24 and pedestal 44. Application of RF energy from BRF generators 36 and 50 to bias an inductively coupled plasma toward pedestal 44 promotes sputtering and enhances existing sputtering effects of the plasma (i.e., increasing the gap-fill capability of a film).

Capacitive coupling may also be used to form the plasma. Such a plasma may be formed between ceiling electrode 24 and pedestal 44 or in a similar fashion.

BRF generators 36 and 50, SRF generator 32, throttle valve 12a, the MFCs connected to lines 27, switches 30, 34, 38 and 52, and other elements in CVD system 5 are all controlled by a system controller 31 over control lines 35, only some of which are shown. System controller 31 operates under the control of a computer program stored in a computer-readable medium such as a memory 33, which, in the preferred embodiment is a hard disk drive. The computer program dictates the timing, introduction rate and mixture of gases, chamber pressure, chamber temperature, RF power levels and other parameters of a particular process. Motors and optical sensors are used to move and determine the position of movable mechanical assemblies such as throttle valve 12a and pedestal 44.

System controller 31 controls all of the activities of the CVD machine. In a preferred embodiment, controller 31 includes a hard disk drive (memory 33), a floppy disk drive, and a card rack. The card rack contains a single board computer (SBC) 37, analog and digital input/output boards, interface boards and stepper motor controller boards (only some of which are shown). The system controller conforms to the Versa Modular Europeans (VME) standard which defines board, card cage, and connector dimensions and types. The VME also defines the bus structure having a 16-bit data bus and 24-bit address bus.

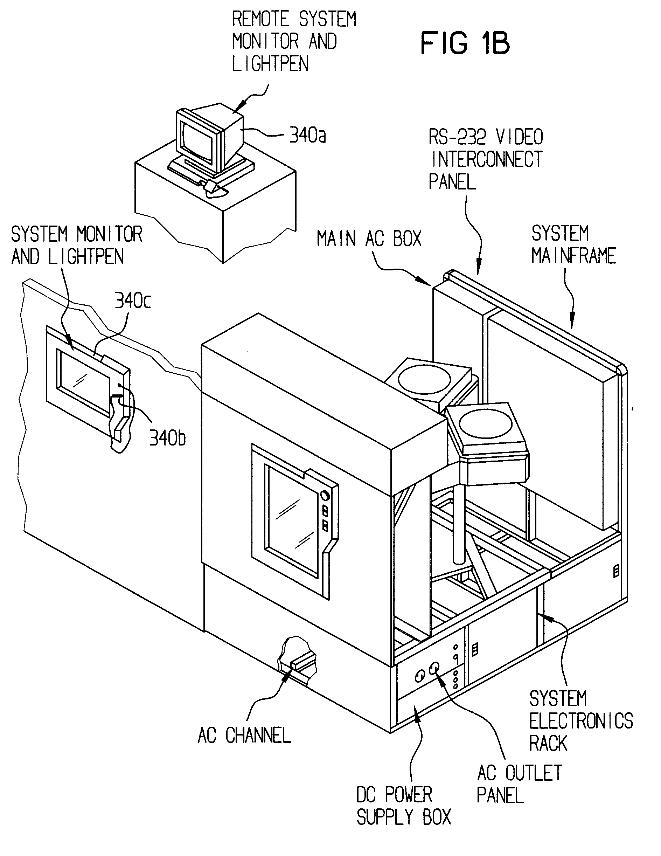

System controller 31 operates under the control of a computer program stored on the hard disk drive. The computer program dictates the timing, mixture of gases, RF power levels and other parameters of a particular process. The interface between a user and the system controller is via a CRT monitor 340a and a lightpen 340b which is depicted in Fig. 1B. In the preferred embodiment two monitors 340a are used, one mounted in the clean room wall for the operators and the other behind the wall for the service technicians. Both monitors 340a simultaneously display the same information, but only one lightpen 340b is enabled. Lightpen 340b detects light emitted by CRT display with a light sensor in the tip of the pen. To select a particular screen or function, the operator touches a designated area of the display screen and pushes the button on pen 340b. The touched area changes its highlighted color, or a new menu or screen is displayed, confirming communication between the lightpen and the display screen.

The process can be implemented using a computer program product 141 that runs on, for example, system controller 31. The computer program code can be written in any conventional computer readable programming language such as for example 68000 assembly language, C, C++, or Pascal. Suitable program code is entered into a single file, or multiple files, using a conventional text editor, and stored or embodied in a computer usable medium, such as a memory system of the computer. If the entered code text is in a high level language, the code is compiled, and the resultant compiler code is then linked with an object code of precompiled windows library routines. To execute the linked compiled object code, the system user invokes the object code, causing the computer system to load the code in memory, from which the CPU reads and executes the code to perform the tasks identified in the program.

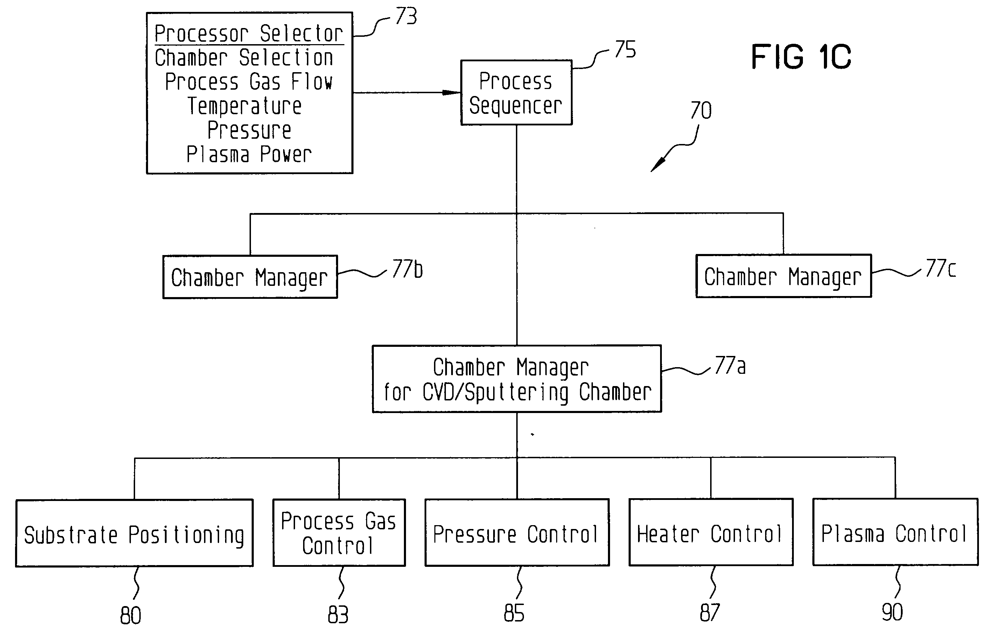

Fig. 1C shows an illustrative block diagram of the hierarchical control structure of computer program 70. A user enters a process set number and process chamber number into a process selector subroutine 73 in response to menus or screens displayed on the CRT monitor by using the lightpen interface. The process sets are predetermined sets of process parameters necessary to carry out specified processes, and are identified by predefined set numbers. The process selector subroutine 73 identifies (i) the desired process chamber in a multichamber system, and (ii) the desired set of process parameters needed to operate the process chamber for performing the desired process. The process parameters for performing a specific process relate to process conditions such as, for example, process gas composition and flow rates, temperature, pressure, plasma conditions such as RF bias power levels and magnetic field power levels, cooling gas pressure, and chamber wall temperature and are provided to the user in the form of a recipe. The parameters specified by the recipe are entered utilizing the lightpen/CRT monitor interface.

The signals for monitoring the process are provided by the analog input and digital input boards of system controller and the signals for controlling the process are output on the analog output and digital output boards of system controller 31.

A process sequencer subroutine 75 comprises program code for accepting the identified process chamber and set of process parameters from the process selector subroutine 73, and for controlling operation of the various process chambers. Multiple users can enter process set numbers and process chamber numbers, or a user can enter multiple process set numbers and process chamber numbers, so sequencer subroutine 75 operates to schedule the selected processes in the desired sequence. Preferably, sequencer subroutine 75 includes a program code to perform the steps of (i) monitoring the operation of the process chambers to determine if the chambers are being used, (ii) determining what processes are being carried out in the chambers being used, and (iii) executing the desired process based on availability of a process chamber and type of process to be carried out. Conventional methods of monitoring the process chambers can be used, such as polling. When scheduling which process is to be executed, sequencer subroutine 75 can be designed to take into consideration the present condition of the process chamber being used in comparison with the desired process conditions for a selected process, or the "age" of each particular user entered request, or any other relevant factor a system programmer desires to include for determining scheduling priorities.

After sequencer subroutine 75 determines which process chamber and process set combination is going to be executed next, sequencer subroutine 75 causes execution of the process set by passing the particular process set parameters to a chamber manager subroutine 77a-c which controls multiple processing tasks in process chamber 10 according to the process set determined by sequencer subroutine 75. For example, chamber manager subroutine 77a comprises program code for controlling sputtering and CVD process operations in process chamber 10. Chamber manager subroutine 1440 also controls execution of various chamber component subroutines which control operation of the chamber components necessary to carry out the selected process set.

Examples of chamber component subroutines are substrate positioning subroutine 80, process gas control subroutine 83, pressure control subroutine 85, heater control subroutine 87, and plasma control subroutine 90. Those having ordinary skill in the art will recognize that other chamber control subroutines can be included depending on what processes are desired to be performed in process chamber 10. In operation, chamber manager subroutine 77a selectively schedules or calls the process component subroutines in accordance with the particular process set being executed. Scheduling by chamber manager subroutine 77a is performed in a manner similar to that used by sequencer subroutine 75 in scheduling which process chamber 10 and process set is to be executed. Typically, chamber manager subroutine 77a includes steps of monitoring the various chamber components, determining which components need to be operated based on the process parameters for the process set to be executed, and causing execution of a chamber component subroutine responsive to the monitoring and determining steps.

Operation of particular chamber component subroutines will now be described with reference to Fig. 1C. Substrate positioning subroutine 80 comprises program code for controlling chamber components that are used to load a substrate onto pedestal 44 and to move the pedestal to a processing position. Substrate positioning subroutine 80 may also control transfer of a substrate into chamber 10 from, e.g., a PECVD reactor after other processing has been completed.

Process gas control subroutine 83 has program code for controlling process gas composition and flow rates. Subroutine 83 controls the open/close position of the safety shut-off valves, and also ramps up/down the mass flow controllers to obtain the desired gas flow rate. All chamber component subroutines, including process gas control subroutine 83, are invoked by chamber manager subroutine 77a. Subroutine 83 receives process parameters from the chamber manager subroutine related to the desired gas flow rates. Typically, process gas control subroutine 83 operates by opening the gas supply lines, and repeatedly (i) reading the necessary mass flow controllers, (ii) comparing the readings to the desired flow rates received from chamber manager subroutine 77a, and (iii) adjusting the flow rates of the gas supply lines as necessary. Furthermore, process gas control subroutine 83 includes steps for monitoring the gas flow rates for unsafe rates, and activating the safety shut-off valves when an unsafe condition is detected.

In some processes, an inert gas such as argon is flowed into chamber 10 to stabilize the pressure in the chamber before reactive process gases are introduced into the chamber. For these processes, the process gas control subroutine 83 is programmed to include steps for flowing the inert gas into chamber 10 for an amount of time necessary to stabilize the pressure in the chamber. The above-described steps may then be carried out. Additionally, when a process gas is to be vaporized from a liquid precursor, for example tetraethylorthosilane (TEOS), the process gas control subroutine 83 includes steps for bubbling a delivery gas such as helium through the liquid precursor in a bubbler assembly or for introducing the helium to a liquid injection valve. For this type of process, the process gas control subroutine 83 regulates the flow of the delivery gas, the pressure in the bubbler, and the bubbler temperature to obtain the desired process gas flow rates. As discussed above, the desired process gas flow rates are transferred to process gas control subroutine 83 as process parameters. Furthermore, the process gas control subroutine 83 includes steps for obtaining the necessary delivery gas flow rate, bubbler pressure, and bubbler temperature for the desired process gas flow rate by accessing a stored table containing the necessary values for a given process gas flow rate. Once the necessary values are obtained, the delivery gas flow rate, bubbler pressure and bubbler temperature are monitored, compared to the necessary values and adjusted accordingly.

Pressure control subroutine 85 includes program code for controlling the pressure in chamber 10 by regulating the size of the opening of throttle valve 12a in the exhaust portion of the chamber. The size of the opening of throttle valve 12a is set to control the chamber pressure to the desired level in relation to the total process gas flow, size of the process chamber, and pumping setpoint pressure for the exhaust system. When pressure control subroutine 85 is invoked, the desired, or target, pressure level is received as a parameter from chamber manager subroutine 77a. Pressure control subroutine 147 operates to measure the pressure in chamber 10 by reading one or more conventional pressure nanometers connected to the chamber, compare the measure value(s) to the target pressure, obtain proportional, integral, and differential (PID) values from a stored pressure table corresponding to the target pressure, and adjust the throttle valve 12a according to the PID values obtained from the pressure table. Alternatively, pressure control subroutine 85 can be written to open or close throttle valve 12a to a particular opening size to regulate chamber 10 to attain a desired pressure.

Heater control subroutine 87 comprises program code for controlling the temperature of chamber 10. Heater control subroutine 87 is also invoked by chamber manager subroutine 77a and receives a target, or setpoint, temperature parameter. Heater control subroutine 87 measures the temperature by measuring voltage output of a thermocouple located in pedestal 44, compares the measured temperature to the setpoint temperature, and increases or decreases current applied to the resistive heating element 60 (or to BRF generators 30, 50 as needed) to obtain the setpoint temperature. The temperature is obtained from the measured voltage by looking up the corresponding temperature in a stored conversion table, or by calculating the temperature using a fourth order polynomial.

Plasma control subroutine 90 comprises program code for setting the RF voltage power level applied to RF generators 32, 36 and 50 in chamber 10, and optionally, to set the level of the magnetic field generated in the chamber. The plasma control subroutine 90, like the previously described chamber component subroutines, is invoked by chamber manager subroutine 77a.

An example of such an HDP CVD apparatus along with the advantages of each of the three capacitively coupled configurations and the specific details concerning the inductively coupled configurations is described in U.S. Patent Application 08/234,746 entitled "High Density Plasma CVD Reactor with Combined Inductive and Capacitive Coupling," by Nowak, Fairbairn and Redeker, filed April 26, 1994, the disclosure of which is incorporated herein by reference.

### B. An Exemplary Parallel Plate, Capacitively Coupled CVD Reactor Chamber

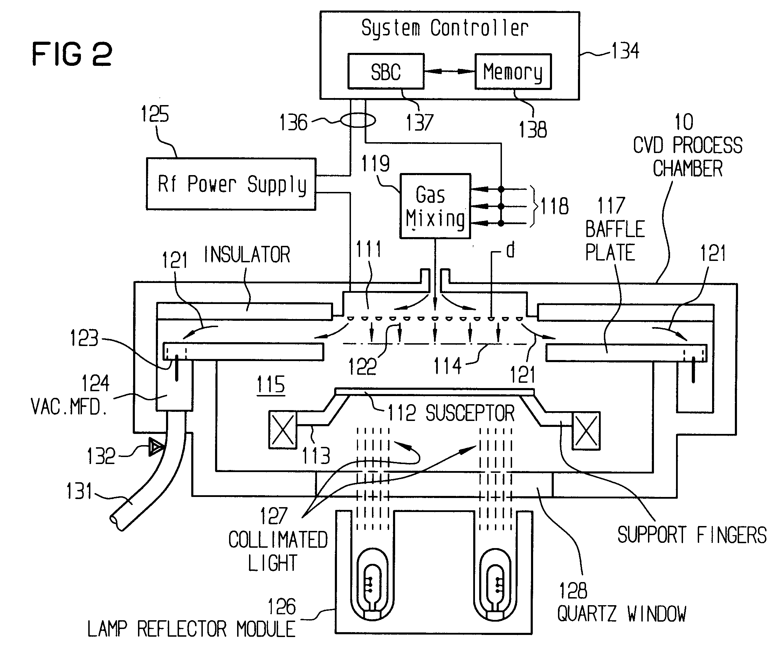

Fig. 2 illustrates another embodiment of a CVD system in which the dielectric layer of the present invention can be deposited. Fig. 2 is a simplified, parallel plate plasma-enhanced chemical vapor deposition (PECVD) system 110 that has a housing defining a vacuum chamber 115. System 110 contains a gas distribution manifold 111 for dispersing deposition gases to a wafer (not shown) that rests on a susceptor 112 within vacuum chamber 115. Susceptor 112 is highly thermally responsive and is mounted on supports 113 so that susceptor 112 (and the wafer supported on the upper surface of susceptor 112) can be moved controllably between a lower loading/off-loading position and an upper processing position 114 that is closely adjacent to manifold 111.

When susceptor 112 and the wafer are in processing position 114, they are surrounded by a baffle plate 117 having a plurality of spaced holes 123 that exhaust into an annular vacuum manifold 124. Deposition and carrier gases and liquids are supplied through lines 118, having control valves (not shown), into a gas mixing chamber 119 where they are combined and then sent to manifold 111. During processing, gas inlet to manifold 111 is vented toward and uniformly distributed radially across the surface of the wafer as indicated by arrows 122 and 121. The gas is then exhausted via ports 123 into the circular vacuum manifold 124 and out an exhaust line 131 by a vacuum pump system (not shown). The rate at which gases are released through exhaust line 131 is controlled by a throttle valve 132.

A controlled plasma is formed adjacent to the wafer by RF energy applied to manifold 111 from RF power supply 125. Gas distribution manifold 111 is also an RF electrode, while susceptor 112 is grounded. RF power supply 125 can supply either single or mixed frequency RF power (or other desired variation) to manifold 111 to enhance the decomposition of reactive species introduced into chamber 115.

A circular external lamp module 126 provides a collimated annular pattern of light 127 through quartz window 128 onto susceptor 112. Such heat distribution compensates for the natural heat loss pattern of the susceptor, and provides rapid and uniform heating of the susceptor and wafer for effecting deposition.

A motor (not shown) raises and lowers susceptor 112 between a processing position 114 and a lower, wafer-loading position. The motor, control valves connected to lines 118, throttle valve, and RF power supply 125 are controlled by a system controller 134 over control lines 136 of which only some are shown. System controller 134 includes a processor (SBC) 137 that operates under the control of a computer program stored in a computer-readable medium such as a memory 138. The computer program dictates the timing, mixture of gases, chamber pressure, chamber temperature, RF power levels, susceptor position, and other parameters of a particular process in a manner similar to that described with respect to system controller 31.

Typically, any or all of the chamber lining, gas inlet manifold faceplate, support fingers 113, and various other reactor hardware are fabricated from material such as aluminum and/or anodized aluminum. An example of such a PECVD apparatus is described in U.S. Patent 5,000,113 entitled "Thermal CVD/PECVD Reactor and Use for Thermal Chemical Vapor Deposition of Silicon Dioxide and In-situ Multi-step Planarized Process," which is commonly assigned and hereby incorporated by reference.

The above CVD system descriptions are mainly for illustrative purposes and should not be considered as limiting the scope of the present invention. Variations of the above described systems such as variations in platen or susceptor design, heater design, location of RF power connections and others are possible. Additionally, other plasma CVD equipment such as electron cyclotron resonance (ECR) plasma CVD devices or the like may be employed. The method for controlling the stress of a silicon oxide layer according to the present invention is not limited to any specific apparatus or to any specific plasma excitation method.

### II. Silicon Oxide Deposition and Stress Control

According to the process of the present invention, the intrinsic stress level of a silicon oxide film deposited in either of the above-described plasma CVD systems or other systems can be precisely controlled by incorporating a select amount of a halogen into the oxide layer. Suitable halogen elements include fluorine, bromine, chlorine and others. Fluorine, however, is the halogen dopant employed in preferred embodiments of the present invention because it is generally less corrosive than other members of the halogen family.

### A. Deposition in a High Density Plasma System

An undoped silicon oxide layer may be deposited in the above described HDP CVD system by reacting a silicon-containing gas such as silane (SiH₄) with an oxygen-containing gas such as O₂. Argon or a similar gas may be incorporated as a sputtering element. A silicon oxide film deposited from these source gases will generally have a dielectric constant between about 3.8 to 4.1 and an intrinsic compressive stress level varying from a high level of about -1.8x10⁹ dynes/cm² to a low level of about -1.2x10⁹ dynes/cm² depending on the process conditions and other factors. Such a stress level, however, is too high and therefore inadequate for many applications. Often, manufacturers prefer that a deposited film have a lower intrinsic stress level within the range of about -0.5x10⁹ to -1.0x10⁹ dynes/cm² or even lower.

According to the method of the present invention, the intrinsic stress of silicon oxide films deposited under HDP CVD or other conditions having a high plasma density (e.g., a plasma density greater than or equal to 10¹¹ ions/cm³) can be tuned to within such a preferred range. In fact, the method of the present invention provides control of the intrinsic stress level of a deposited silicon oxide film over a range of between at least -1.5x10⁹ dynes/cm² to that of a tensile stressed film. Such stress control is achieved by the addition of a halogen element, preferably fluorine, to the reaction. The fluorine may be introduced from a variety of different fluorine sources such as SiF₄, C₂F₆ or CF₄ among other sources.

Only a relatively small amount of fluorine is introduced into the chamber to exact such stress control in a silicon oxide film. The introduction of a small amount of fluorine provides a point of stress control independent from other stress control techniques (e.g., adjustment of RF power). Additionally, when only a small amount of fluorine is added to the reaction, other film properties, such as film uniformity and stability, are not adversely effected.

To prove the effectiveness of the method of the present invention, experiments were performed depositing a 1.0 mm thick fluorine-doped silicon oxide film over a low resistivity silicon wafer in an HDP CVD chamber manufactured by Applied Materials. The silicon oxide film was deposited from a deposition gas that included silane, oxygen, and argon. CF₄ was also added to the deposition gas as a source of fluorine.

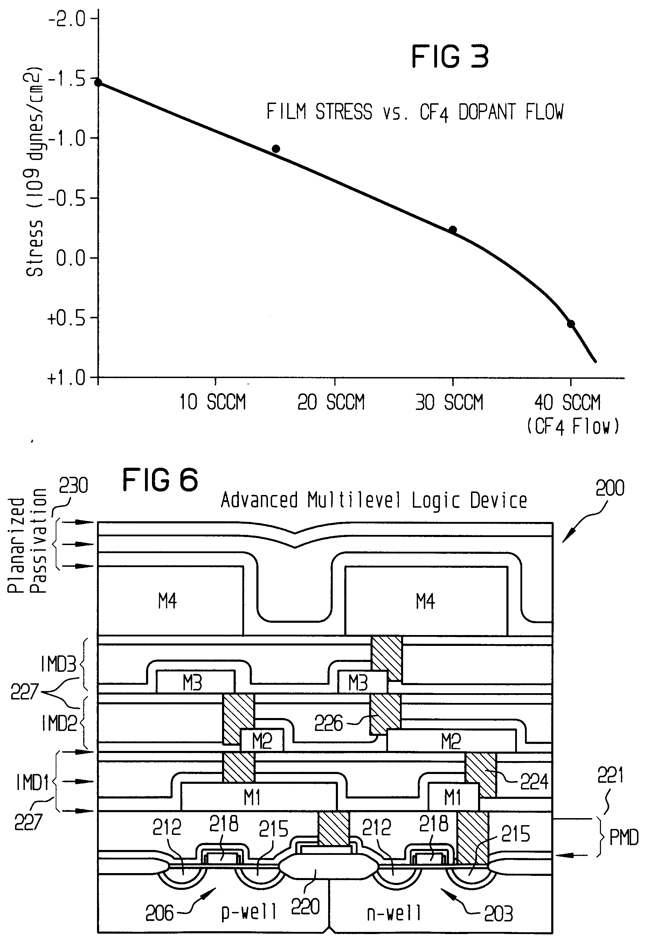

For the experiments, the rate at which silane, oxygen, and argon were introduced into the chamber remained constant. The rate at which CF₄ was introduced into the reaction chamber was varied in order to vary the concentration of fluorine incorporated into the film. Specifically, silane was introduced into the chamber at a rate of 60 sccm, oxygen was introduced into the chamber at a rate of 96 sccm, and argon was introduced at a rate of 20 sccm. The temperature within the reactor chamber was set and maintained at about 400°C and the pressure within the chamber was maintained at about 3 millitorr. A plasma was formed by setting the source RF power (2.0 Hz) to 3500 Watts and setting the bias RF power (1.8 Hz) to 2500 Watts. Such gas flow, temperature, pressure and RF power levels are the standard, optimized values of one particular process used to deposit undoped silicon oxide films in the HDP CVD chamber. The rate at which CF₄ was introduced in the experiments varied from 0 sccm to 40 sccm. The results of these experiments are summarized in Table 1 below and are also depicted graphically in Fig. 3, which plots film stress versus CF₄ dopant flow.

**TABLE 1**

| **Stress as a function of fluorine concentration** | | |
|---|---|---|
| **CF**_{**4**} **Flow Rate (sccm)** | **Ratio of CF**_{**4**} **to SiH**_{**4**} | **Stress (dynes/cm**^{**2**}**)** |
| 0 | 0 | -1.45 |
| 15 | 0.25 | -0.9 |
| 30 | 0.5 | -0.25 |
| 40 | 0.67 | +0.5 |

As evident from both Table 1 and Fig. 3, the stress of the deposited film can be controlled by adjusting the CF₄ flow rate. In the experiments, the intrinsic stress of the deposited film varied from a high of about -1.45x10⁹ dynes/cm² to 0.5 dynes/cm² depending on the rate at which CF₄ was introduced into the reaction. All stress measurements were taken with a Flexus 2320 stress temperature gauge manufactured by Tencor Instruments.

An undoped silicon oxide film deposited (CF₄ flow equals 0 sccm) exhibited a compressive stress level of -1.45x10⁹ dynes/cm² under the above conditions. Introducing a relatively small amount of CF₄ into the reaction, however, reduced the film stress to -0.9x10⁹ dynes/cm². Increasing the rate at which CF₄ is introduced into the chamber resulted in a further decrease of the film stress. When CF₄ was introduced at a rate of 30 sccm, film stress dropped to -0.25x10⁹ dynes/cm². The film even exhibited a tensile stress level of +0.5 dynes/cm² when the CF₄ flow rate was increased to 40 sccm.

As confirmed by the above experiment, introducing fluorine into the deposition chamber provides a mechanism to control stress of the deposited film without adversely effecting other characteristics of the film. Specifically, introducing a relatively small amount of fluorine (between about 10-25 sccm) in this particular application allows the stress of the silicon oxide layer deposited under HDP CVD conditions to be controlled within a desired range of -1.0 to -0.5x10⁹ dynes/cm². At such relatively low introduction rates, the gap fill and uniformity characteristics of each film were essentially unchanged with the increase in the rate at which CF₄ was introduced from 0 to 25 sccm. Additionally, the dielectric constant of the films was not significantly changed.

Of course, the method of the present invention is not intended to be limited in any manner by the specific parameters set forth in the above experiments. A person of ordinary skill in the art will realize that different processing conditions and different reagent sources can be used without departing from the spirit of the invention. For example, silicon sources such as tetraethylorthosilicate (TEOS) or others may be used, and oxygen sources such as ozone, N₂O or others may be used. Additionally, other fluorine sources such as C₂F₆, triethoxyfluorosilane (TEFS), SiF₄, and the like may be employed to lower the intrinsic stress level of the deposited film. Also, the rate at which individual gases are introduced into the chamber depends in part on the gases used, chamber design and chamber volume. Gas introduction rates will be different in different chambers and/or with different gases.

### B. Deposition in a Capacitively Coupled, Parallel Plate CVD Reactor

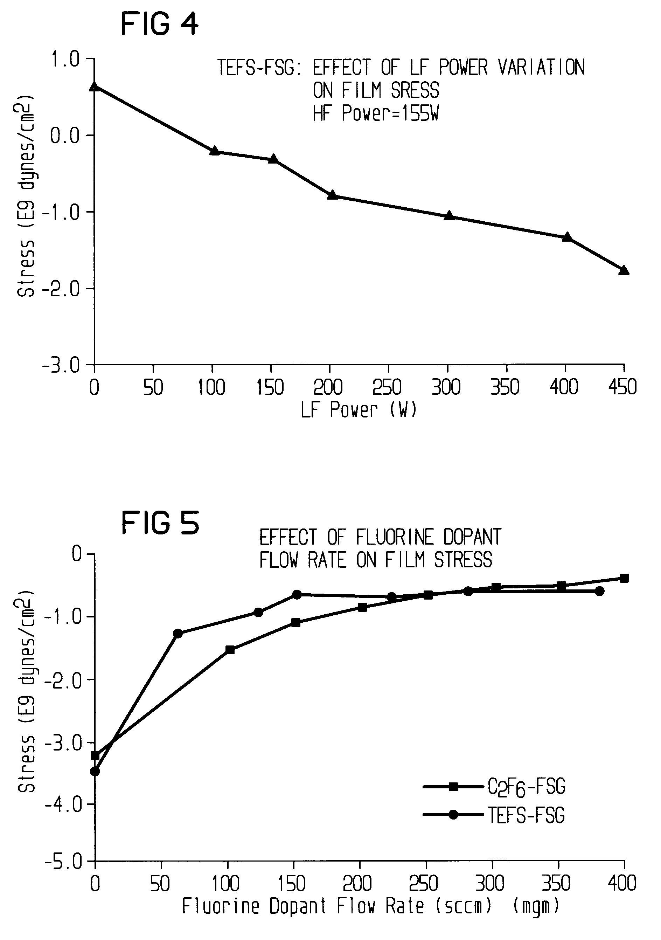

Prior to the present invention, the stress of FSG films deposited in a capacitively coupled PECVD system such as the one described above was commonly controlled by adjusting the low frequency RF power. For example, as shown in Fig. 4, which is a graph showing the intrinsic stress of deposited TEFS-FSG films versus low frequency RF power, increasing the RF power results in an increase in film stress.

In Fig. 4, a TEFS-FSG film was deposited over a low resistivity silicon wafer in a P5000 PECVD chamber manufactured by Applied Materials. The film was deposited at a pressure of 5 torr and a temperature of 400°C. The high frequency RF power supply of 13.56 MHz was powered at 155 Watts and the low frequency RF power supply of 350 KHz was powered at 230 Watts. The susceptor was positioned 250 mil from the gas distribution manifold. TEOS was introduced at a flow rate of 260 mgm and oxygen was introduced into the chamber at a rate of 1250 sccm. TEFS was introduced at a rate of 230 mgm.

As evident in Fig. 4, varying the low frequency RF power in the above process conditions can tune the intrinsic stress level of the deposited FSG film from about 0.7x10⁹ dynes/cm² to about -1.6x10⁹ dynes/cm². Since many applications require that the stress level of an FSG film be in the range of about -0.5x10⁹ dynes/cm² to -1.0x10⁹ dynes/cm², it is preferable that the low frequency RF power for a TEFS-FSG film deposited under the above conditions be set between about 150-350 Watts. Experiments have also shown, however, that as the low frequency RF power is increased over this range, film uniformity and the wet-etch rate decrease.

The method of the present invention provides an additional mechanism to control or tune the stress level of PECVD films so that it is not necessary to alter the low frequency RF power to control the film stress level. Specifically, the method of the present invention provides for the intrinsic stress level of a deposited FSG film to be controlled by varying the rate at which the fluorine-containing source is introduced into the reaction chamber. For example, as shown in Fig. 5, which is a graph showing the effect of fluorine dopant flow on the intrinsic stress level of a silicon oxide film deposited in a P5000 reactor outfitted for 200 mm wafers and manufactured by Applied Materials. Experiments show that the stress of TEFS-FSG and C₂F₆-FSG films can be controlled from about -3.4x10⁹ dynes/cm² to at least -0.5x10⁹ dynes/cm² by varying the rate at which either TEFS or C₂F₆ is introduced into the reaction chamber.

The C₂F₆-FSG film of Fig. 5 was deposited on a low resistivity silicon wafer at a pressure of 5 torr and a temperature of 400°C. A plasma was formed from the C₂F₆ source gas, TEOS, and oxygen using a frequency of 13.56 MHz at 200 Watts, and a lower frequency of 350 KHz at 430 Watts. The susceptor was positioned 250 mil from the gas distribution manifold. TEOS was introduced at a flow rate of 260 mgm and oxygen was introduced at a rate of 1000 sccm. The rate at which C₂F₆ was introduced into the chamber varied between 0-380 sccm.

As evident from Fig. 5, the intrinsic stress of a C₂F₆-FSG film deposited under the above conditions can be tuned from a high level of about -3.2x10⁹ dynes/cm² to a low level of about -0.3 dynes/cm² by adjusting the rate at which C₂F₆ is introduced into the chamber. When C₂F₆ was left out of the reaction, the stress level of the deposited film was about -3.2x10⁹ dynes/cm². Introducing C₂F₆ at a rate of 95 sccm reduced the intrinsic stress of the film to -1.7x10⁹ dynes/cm². The level of stress in the deposited film was within the preferred range of -1.0x10⁹ dynes/cm² to -0.5x10⁹ dynes/cm² when C₂F₆ flow rate was about 200-350 sccm.

The TEFS-FSG film of Fig. 5 was also deposited on a low resistivity silicon wafer at a pressure of 5 torr and a temperature of 400°C. The process used a high frequency RF power source of 13.56 MHz powered at 155 Watts and a low frequency RF power source of 350 KHz powered at 230 Watts. The susceptor was positioned 250 mil from the gas distribution manifold. TEOS was introduced at a flow rate of 260 mgm and oxygen was introduced into the chamber at a rate of 1250 sccm. The rate at which TEFS was introduced into the chamber varied between 0-400 mgm.

The intrinsic stress of the TEFS-FSG film deposited under the above conditions can be controlled from a high level of about -3.4x10⁹ dynes/cm² to a low level of about -0.6 dynes/cm² by setting the appropriate rate at which TEFS is introduced into the reaction chamber. When TEFS was left out of the reaction, the stress level of the deposited film was about - 3.4x10⁹ dynes/cm². Introducing TEFS at a rate of 50 mgm reduced the intrinsic stress of the film to -1.3x10⁹ dynes/cm². The level of stress in the deposited film was within the preferred range of -1.0x10⁹ dynes/cm² to - 0.5x10⁹ dynes/cm² when TEFS flow rate was about 150-380 mgm.

Thus, as shown in Fig. 5, the intrinsic stress level of a silicon oxide film can be controlled to a specified level by selecting an appropriate rate at which the fluorine-containing source is introduced. The actual stress of the deposited film is directly related to the amount of fluorine introduced into the reaction chamber film.

The appropriate rate at which the fluorine source is introduced for a particular process can be determined in a variety of different manners. For example, previous tests using the particular process with varied fluorine introduction rates could have been performed and the results of these tests compiled into a look-up table or similar database. The results of these tests (e.g., the database) could be consulted to determine the appropriate fluorine introduction rate to deposit a film having a stress level of x for that particular recipe. The database may be stored in a computer-readable medium and accessed by processor 31. Memory 33 may contain a program that calculates the appropriate fluorine introduction rate to deposit a film of stress level x for a particular process based, in part, on the stored database.

In an alternative example, one or more wafers may be processed to deposit a film using a particular process and introducing fluorine at a selected rate of introduction. After deposition of the film, the intrinsic stress level of the film may be measured. If the measured stress level is too high, a subsequent process can deposit a film using an increased fluorine introduction rate. If the measured stress level is too low, a subsequent process can deposit a film using a decreased fluorine introduction rate. This process may be repeated until the desired stress level is obtained.

In using the rate at which the fluorine source is introduced into the reaction chamber as a stress control mechanism, it is important to be able to precisely control the introduction of the fluorine source. It is also important that the rate at which the fluorine source is introduced remains substantially constant throughout deposition. To this end, if the fluorine-containing source is in liquid form at room temperature, e.g., TEFS, it is preferable to use a liquid injection system such as the Precision Liquid Injection System (PLIS) developed by Applied Materials rather than a conventional bubbler-type system. The use of a liquid injection system allows more precise control over the rate of introduction of the liquid fluorine source than conventional bubbler-type systems. Also, use of a liquid injection valve system to introduce a liquid fluorine source allows the precise rate at which the fluorine source is introduced to be maintained substantially constant throughout deposition. Thus, use of a liquid injection system allows more precise control over the intrinsic stress level of the deposited film. An example of such a PLIS system is described in U.S. Serial No. 07/990,755 entitled Vaporizing Reactant Liquids for Chemical Vapor Deposition Film Processing and having Visweswaren Sivaramakrishnan and John White as inventors. The 07/990,755 application is assigned to Applied Materials, Inc. and is hereby incorporated by reference.

Of course, the method of the present invention is not intended to be limited in any manner by the specific parameters set forth in the above experiments and is not intended to be limited to the particular liquid injection system described. A person of ordinary skill in the art will realize that different processing conditions and different reagent sources can be used without departing from the spirit of the invention. For example, silicon sources such as silane or others may be used, and oxygen sources such as ozone, N₂O or others may be used. Additionally, other fluorine sources such as CF₄, SiF₄ and the like may be employed to lower the intrinsic stress level of the deposited film. A person of ordinary skill in the art will also recognize that liquid injection systems other than the described PLIS system can be used to precisely control the amount of fluorine introduced into the reaction chamber when the fluorine-containing source is in liquid form.

### III. Exemplary Structure

Fig. 6 illustrates a simplified cross-sectional view of an integrated circuit 200 according to the present invention. As shown, integrated circuit 200 includes NMOS and PMOS transistors 203 and 206, which are separated and electrically isolated from each other by a field oxide region 220. Each transistor 203 and 206 comprises a source region 212, a drain region 215 and a gate region 218.

A premetal dielectric layer 221 separates transistors 203 and 206 from metal layer M1 with connections between metal layer M1 and the transistors made by contacts 224. Metal layer M1 is one of four metal layers, M1-M4, included in integrated circuit 200. Each metal layer M1-M4 is separated from adjacent metal layers by respective inter-metal dielectric layers 227 (IMD1, IMD2 and IMD3). Adjacent metal layers are connected at selected openings by vias 226. Deposited over metal layer M4 are planarized passivation layers 230.

While the method of the present invention may be used to control the stress in each of the dielectric layers shown in integrated circuit 200, physical properties of the resulting film such as its low dielectric constant and good gap-fill properties make the method most useful for controlling the stress of an insulation layer between adjacent metal layers as shown by IMD layers IMD1-IMD3. Typically, such IMD layers are between 0.2-3.0 mm thick.

The method of the present invention may also be used to control the stress of damascene layers which are included in some integrated circuits. In damascene layers, a blanket FSG layer is deposited over a substrate, selectively etched through and then filled with metal and etched back or polished to form metal layers such as M1. After the metal layer is deposited, a second blanket FSG deposition is performed and selectively etched. The etched areas are then filled with metal and etched back or polished to form vias 226.

It should be understood that the simplified integrated circuit 200 is for illustrative purposes only. One of ordinary skill in the art could implement the present method for fabrication of other integrated circuits such as microprocessors, application specific integrated circuits (ASICS), memory devices, and the like. Additionally, the method of the present invention may be used in the fabrication of integrated circuits using technologies such as BiCMOS, NMOS, bipolar and others.

## Claims

1. In a processing chamber, a method of depositing a layer having a predetermined intrinsic stress level over a substrate, said method including the steps of:
(a) distributing a halogen source to said processing chamber at a selected rate, said selected rate being chosen according to said predetermined stress level;
(b) introducing a process gas comprising silicon, oxygen and said halogen source into said chamber; and
(c) forming a plasma from said process gas to deposit said layer having said predetermined intrinsic stress level over said substrate.

2. The method of claim 1, further comprising the steps of:
(d) repeatedly performing steps (a) through (c) to deposit a halogen-doped silicon oxide film on a plurality substrates;
(e) measuring the intrinsic stress of said deposited halogen-doped silicon oxide film on each of said plurality of substrates; and
(f) if said intrinsic stress of said deposited halogen-doped silicon oxide films is too high, increasing said selected rate at which said halogen source is introduced during deposition of a halogen-doped silicon oxide film over a subsequently processed substrate to lower the intrinsic stress of said subsequently deposited halogen-doped silicon oxide film, and if said intrinsic stress of said deposited halogen-doped silicon oxide films is too low, decreasing said selected rate at which said halogen source is introduced during deposition of a halogen-doped silicon oxide film over a subsequently processed substrate to increase the intrinsic stress of said subsequently deposited halogen-doped silicon oxide film.

3. The method of claim 1, wherein said selected rate is determined from a database of measured intrinsic stress levels of previously deposited films.

4. The method of claim 1, wherein said halogen source comprises a fluorine source which is preferably selected from the group of: CF₄, C₂F₆, SiF₄ and TEFS.

5. The method of claim 1, wherein said silicon source comprises TEOS.

6. The method of claim 4, wherein said fluorine source is introduced at a rate that is 20% or less of total gas flow into said chamber.

7. The method of claim 4, wherein said fluorine source is CF₄ and is introduced at a rate that is 10% or less of the total gas flow into said chamber.

8. A substrate processing system for carrying out the method according to one of the claims 1 to 7 comprising:
a housing for forming a vacuum chamber;
a substrate holder, located within said housing, for holding a substrate;
a gas delivery system configured to introduce a process gas into said vacuum chamber;
a plasma generation system configured to form a plasma from said process gas;
a controller for controlling said gas delivery system and said plasma generation system; and
a programmable computer for controlling said gas delivery system to introduce said halogen source into said gas mixing area at a selected rate so that said deposited layer has a predetermined intrinsic stress level.

9. A substrate processing system according to claims 8, wherein said computer comprises a memory coupled to said controller comprising a computer readable medium having a computer readable program embodied therein for directing operation of said substrate processing system, said computer readable program comprising:
a first set of instructions for controlling said gas delivery system to introduce a process gas comprising silicon, oxygen, and a halogen source into said gas mixing area; and
a second set of instructions for controlling said plasma generation system to form a plasma from said gases by said first set of instructions to deposit a layer over said substrate;
whereby said first set of instructions controls said gas delivery system to introduce said halogen source into said gas mixing area at a selected rate so that said deposited layer has a predetermined intrinsic stress level.

10. The substrate processing system of claim 8 or 9, wherein said plasma generation system comprises an inductive coil coupled to an RF power supply, said inductive coil at least partially surrounding said vacuum chamber; and
wherein said plasma formed by said plasma generation system has an ion density of at least 10¹¹ ions/cm³.
